# EUROPEAN PATENT SPECIFICATION

(11) **EP 3 294 046 B1**
(45) Date of publication and mention of the grant of the patent: **02.08.2023**
(21) Application number: 16188098.4
(22) Date of filing: 09.09.2016
(51) Int. Cl.: H05K 1/02, H05K 1/18

(54) **SOLID STATE LIGHTING MODULE AND METHOD OF FABRICATING SAME**
FESTKÖRPERBELEUCHTUNGSMODUL UND VERFAHREN ZUR HERSTELLUNG DAVON
MODULE D'ÉCLAIRAGE À SEMI-CONDUCTEUR ET SON PROCÉDÉ DE FABRICATION

(43) Date of publication of application: 14.03.2018
(73) Proprietor: TE Connectivity Germany GmbH, 64625 Bensheim (DE); Tyco Electronics Belgium EC BVBA, 8020 Oostkamp (BE)
(72) Inventor: MICHAEL, Mathias, 68789 St. Leon-Rot (DE); WETZEL, Hans-Joachim, 80935 München (DE); RADI, Marwan, 68766 Hockenheim (DE); LEEMAN, Reginald, 8400 Oostende (BE)
(74) Representative: Grünecker Patent- und Rechtsanwälte PartG mbB

(56) References cited:
- EP-A2- 2 621 252
- GB-A- 2 034 102
- JP-A- 2009 042 260
- US-A1- 2012 217 520
- US-A1- 2014 001 498

## Description

The present invention relates to lighting modules, in particular to those that can be used with solid state lighting elements. The present invention further relates to a method of fabricating such a lighting module.

Solid state lighting (SSL) refers to a type of lighting that uses semiconductor light emitting diodes (LEDs), organic light-emitting diodes (OLED), or polymer light emitting diodes (PLED) as sources of illumination. SSL has the potential to provide high-quality, energy-efficient lighting that surpasses traditional technologies and offers a lower life-cycle cost.

Several prior art documents - e.g. JP 2009 042260 A - are concerned with flexible LED modules. From US 2014/001498 A1 and US 2012/217520 A1 it is known that a lighting module comprising a flat flexible carrier and at least one electrically conductive lead can be patterned to form at least one meander loop with at least one cut-out that is provided adjacent to the meander loop in a way that the at least one meander loop partly encircles the cut-out. The concept of a conductive lead on a carrier foil including a meander-shaped region with cut-outs can be found in EP 2 621 252 A2 as well. GB 2 034 102 A applies a similar concept on a cable harness which is originally fabricated in a serpentine pattern and extendable into an elongated linear length.

Moreover, SSL light sources can be assembled on flexible substrates so that the lighting modules can be mounted in tight spaces and on curved surfaces. In particular, conventional SSL lighting modules comprise a plurality of light emitting elements, such as LEDs, that are assembled on a band-shaped flat flexible substrate. The flexible substrate can be bent around curvatures whose radii are normal to the plane defined by the flat flexible substrate. However, in order to be mounted on surfaces that have a more complex structure the flexible substrate would also have to be bent around radii that are parallel to the plane of the substrate. With the known materials this is difficult because the conventional substrates are not elastic and are therefore resistant against such lateral bending.

Consequently, there is a need for an improved lighting module that can be mounted on arbitrary surfaces, but at the same time is economic and simple to fabricate, and is robust and long-term stable also in challenging environments.

This object is solved by the subject matter of the independent claims. Advantageous embodiments of the present invention are the subject matter of the dependent claims.

The present invention is based on the idea that by implementing different meander structures into a flexible printed circuit (FPC) design, it is possible to mount the FPC strip onto a flat or curved surface and also bend the FPC in a planar dimension. Thus, an FPC that is fabricated in a straight shape can be mounted on a carrier that follows a complex shape having bends in more than one dimension.

More specifically, by forming electrically conductive leads that interconnect the light emitting elements and any further electronic components as meander loops, and by additionally providing cut-outs close to these meander loops, a sufficient resiliency can be achieved for the flat flexible substrate being bendable also around a radius that is essentially parallel to the plane defined by the flat flexible substrate. This allows the lighting module to follow the outline of more complex structures, e.g. inside a vehicle.

With "rigid" as used in this application is meant stiff, unyielding, i.e. a rigid structure is not adapted to be deformable during normal use of the structure.

With "flexible" as used in this application is meant non-stiff, non-rigid, i.e. bendable but not stretchable. A flexible structure is adapted to be deformable in a certain direction during normal use of the structure, but does not elongate. The length does not change during bending.

With "stretchable" as used in this application is meant resilient, i.e. elastically deformable with elongation. A stretchable structure is adapted to be elastically deformed during normal use (with elongation). A stretchable structure can be made out of non-stretchable bulk materials, such as flexible materials or even rigid materials.

With "flat flexible carrier" as used in this application is meant an electrically insulating carrier with electrically conductive leads. The invention therefore encompasses flat flexible cables (FFC) and flexible printed circuits (FPC) or any other suitable flexible carrier. The abbreviation "FFC" therefore synonymously is used also for a flat flexible carrier in the following.

According to the present invention, the SSL lighting module comprises a flat flexible carrier (FFC), the carrier comprising at least one electrically insulating flexible substrate with a first surface and a second surface, the substrate preferably having a length in a longitudinal direction which is longer than a breadth extending across the longitudinal axis, and at least one planar electrically conductive lead that is arranged on one of the first or second surfaces of said flexible substrate. At least one light emitting element and the electronic component and/or a second light emitting element are electrically connected to each other by means of said at least one electrically conductive lead. According to the present invention, in at least one stretchable region, said conductive lead is patterned to form at least one meander loop, and said substrate has at least one cut-out that is provided adjacent to the meander loop in a way that the at least one meander loop partly encircles the cut-out.

If the required angle of bending the FFC is not too narrow, it is sufficient to provide elongated holes as the cut-outs, so that in a marginal region of the flexible substrate a web of the carrier material is still present. This enhances the mechanical stability and avoids that the lighting module gets caught at the bending regions during transport and assembly.

However, for smaller bending angles and narrower curvatures, the web inhibits the bending of the substrate and is therefore disadvantageous. In order to allow for even sharper bending, the present invention therefore proposes that the at least one cut-out extends from a margin of the flexible substrate towards an inner region of the substrate, thereby forming an incision that is open at the margin of the substrate. By providing accordingly shaped stretchable regions where a bending around a radius parallel to the plane of the FFC is needed, the lighting module can be mounted on a multitude of differently shaped complex surfaces.

In order to operate the light emitting element(s), the at least one electronic component comprises at least one of a capacitor and an electrical connector to be connected to an external electronic component. he connector may for instance be connected to a power supply and a control unit. Alternatively, also an interface for wireless communication and power supply to the lighting module can be provided as this is known to a person skilled in the art. Moreover, the electronic components of the power supply for driving the light emitting element(s) can also be assembled on the FFC.

As already mentioned, the present invention can advantageously be used with any kind of SSL light emitting element. In the following, mostly the advantageous example of using at least one light emitting diode (LED) is contemplated. LEDs have the advantage that they are cost effective, robust, and well established in the market.

In order to achieve an easy assembly and low height of construction, the light emitting element and/or the electronic component may comprise a surface mount device (SMD).

Furthermore, according to an advantageous embodiment, the at least one electrically conductive lead is covered at least partly by an electrically insulating protective layer. This protective layer firstly provides an electrical insulation of the electrically conductive lead and, secondly, avoids corrosion or abrasion due to environmental influences.

According to an embodiment of the present invention, the flat flexible carrier outside the stretchable region has a first and second margin extending along the longitudinal middle axis, wherein, in the stretchable region, the electrically conductive lead forms at least two meander loops that extend from the longitudinal middle axis further than the first and second margin. By forming the meander loops larger than the breadth of the FFC, the lighting module can be adapted more easily to a complex underground. Moreover, the FFC can be stretched or compressed in order to adjust the distance between the parts of the FFC which are located on both sides of the meander structure. This can help to compensate tolerance differences between the lighting module and the underground it is mounted on. Moreover, different temperature expansion of the materials used can be compensated. Furthermore, the position of the LEDs to each other can be adjusted to optimize the appearance of the light output.

Because the mounting space is limited at the side margins of the FFC strip, those parts of the loops that extend further than the margins, are folded back towards the centre of the flat flexible carrier, so that an essentially straight outline along the first and second margin is formed. It could be shown that the flexibility is not impaired by this folding step.

In order to provide electrical screening, the at least one electrically conductive lead comprises a strip line separated from a grounding plane layer by gaps running in parallel to the strip line.

According to the present invention, the electrically insulating flexible substrate may be fabricated from polyimide, acrylate, or a flexible ceramic material. Polyimide has the advantage that it is cheap, robust, and well-established. However, it has the disadvantage of a poor thermal conductivity. In particular for LEDs, it is therefore preferable to use flexible ceramic which has a much better thermal conductivity.

Moreover, the at least one electrically conductive lead is fabricated from a metal or metal alloy or from a polymer filled with conductive particles.

The electrically conductive lead can be made of any electrically conductive material such as a metal or alloy, such as for instance Cu, Al, Au or TiW, of a polymer filled with conducting material, such as conducting particles e.g. metal particles, carbon nanotubes, etc. The conductive material can be intrinsically conductive polymers or any combinations of the above materials. The electrically conductive lead can be made of two layers of different electrically conductive materials provided on top of each other, such as for instance a first layer being made of a metal and a second layer being made of an electrically conductive silicone. The electrically conductive lead can be made of one or more layers. For instance, the electrically conductive lead comprises a first electrically conductive layer and a second electrically conductive layer, provided on top of each other. Such a double layered electrically conductive channel may increase the lifetime of the electrically conductive channel and of the entire electronic device in the following way. The second electrically conductive layer may be made of a second material which is less brittle and thus has a smaller risk of breaking under stress than the first electrically conductive layer. As a result, in case the first electrically conductive layer would break at certain weak stress sensitive points, the second electrically conductive layer forms a bridge over the cracks electrically connecting the disconnected points of the first electrically conductive layer. This has the advantage that an optimal conductive material can be chosen for the first electrically conductive layer, such as for example copper, even though it may be more brittle and prone to cracking with respect to other conductive materials. When a crack does occur, the second electrically conductive layer, made in a less brittle conductive material, can ensure that there is still a conductive connection over the crack.

In order to facilitate mounting the light emitting element(s) and further electronic components, embedded rigid areas can be provided for assembling the light emitting element(s) and/or the electronic component. In particular, a fully automated reel-to-reel assembly process can be implemented thereby. Moreover, the light emitting element(s) and further electronic components are better protected against mechanical stress and breakage during the assembly and operation of the lighting module in its application environment.

Advantageously, the at least one stretchable region separates regions where at least one light emitting element and/or electronic component are assembled, so that the regions where the light emitting element(s) and further electronic components are mounted, are not deformed. This also protects the light emitting element(s) and further electronic components against mechanical stress and breakage during the assembly and operation of the lighting module.

The present invention further relates to a method of fabricating a lighting module, the method comprising the steps of:
fabricating a flat flexible carrier, the carrier comprising at least one electrically insulating flexible substrate with a first surface and a second surface, the substrate preferably having a length in a longitudinal direction which is longer than a breadth extending across the longitudinal axis, and at least one planar electrically conductive lead that is arranged on one of the first or second surfaces of said flexible substrate; and
assembling at least one light emitting element and at least one electronic component, the light emitting element and the electronic component and/or a second light emitting element being electrically connected to each other by means of said at least one electrically conductive lead;
wherein, in at least one stretchable region, said conductive lead is patterned to form at least one meander loop, and said substrate has at least one cut-out that is provided adjacent to the meander loop in a way that the at least one meander loop encircles the cut-out.

According to the embodiment, the flat flexible carrier outside the stretchable region has a first and second margin extending along the longitudinal middle axis, and wherein, in the stretchable region, the electrically conductive lead forms at least two meander loops that extend from the longitudinal middle axis further than the first and second margin, and wherein the method further comprises the step of folding back towards the centre of the flat flexible carrier the part of the loops that extends further than the margins, so that an essentially straight outline along the first and second margin is formed.

The cut-out is advantageously formed by stamping the flat flexible carrier. This allows the use of stamped laminated foils for fabricating the FFC according to the present invention.

The accompanying drawings are incorporated into the specification and form a part of the specification to illustrate several embodiments of the present invention. These drawings, together with the description serve to explain the principles of the invention. Further features and advantages will become apparent from the following more particular description of the various embodiments of the invention, as illustrated in the accompanying drawings, in which like references refer to like elements, and wherein:
**FIG. 1** is a schematic top view of a detail of a lighting module according to an example not covered by the claims;
**FIG. 2** is a schematic top view of a detail of a lighting module according to an example not covered by the claims;
**FIG. 3** is a schematic top view of a detail of a lighting module according to an example not covered by the claims;
**FIG. 4** shows the arrangement of Fig. 3 in a deformed state;
**FIG. 5** is a schematic top view of a detail of a lighting module according to an example not covered by the claims;
**FIG. 6** is a schematic top view of a detail of a lighting module according to an example not covered by the claims;
**FIG. 7** shows the arrangement of Fig. 6 in a deformed state;
**FIG. 8** is a schematic top view of a detail of a lighting module according to an embodiment;
**FIG. 9** shows the arrangement of Fig. 8 in a deformed state;
**FIG. 10** illustrates the steps of bending and deforming the arrangement of Fig. 8;
FIG. 11 is a schematic top view of a lighting module according to an embodiment;
FIG. 12 depicts the top side of the FFC for the lighting module of Fig. 11;
FIG. 13 depicts the bottom side of the FFC for the lighting module of Fig. 11.

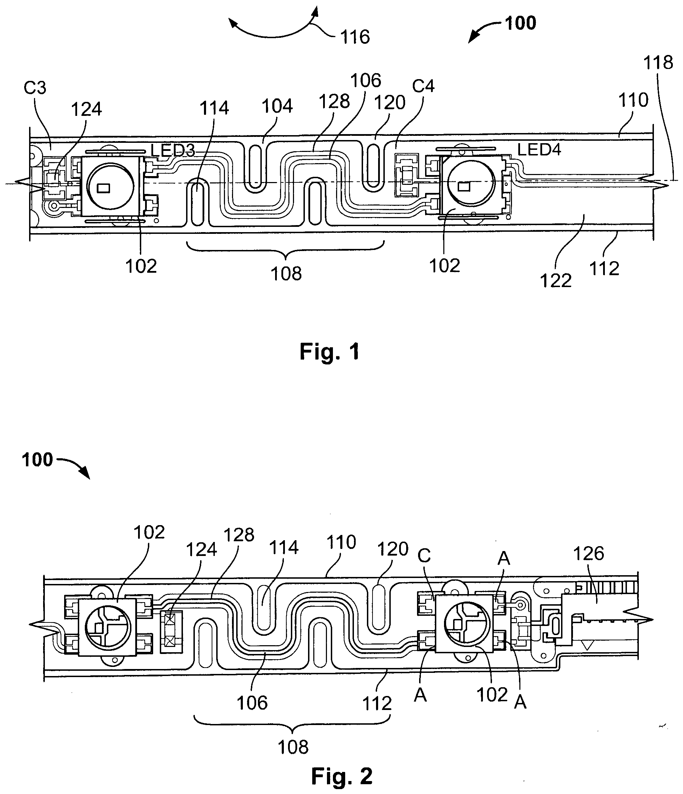

The present invention will now be explained in more detail with reference to the Figures. When first turning to Fig. 1, a perspective view of a detail of a lighting module 100 according to an example not covered by the claims is shown. The lighting module 100 comprises a flat flexible substrate 104 which is fabricated from an electrically insulating material, e.g. from polyimide, acrylate or a flexible ceramic material. Electrically conductive traces which form electrically conductive leads 106 are patterned on the flat flexible substrate 104. The lighting module 100 comprises a plurality of light emitting diodes (LED) 102 which are assembled as surface mount devices (SMD) and are electrically connected to the electrically conductive leads 106.

The lighting module 100 has a stretchable region 108 where the electrically conductive leads 106 are structured to form essentially U-shaped meander loops extending from a first margin 110 to a second margin 112 of the flat flexible substrate 104. Cut-outs 114 are provided which are partly encircled by the meander loops of the electrically conductive leads 106. This meander structure allows a bending around a curvature radius that lies within the plane of the flexible substrate 104 as indicated by the arrow 116, deforming the flat flexible substrate 104 laterally from its straight longitudinal middle axis 118. By providing only comparatively narrow webs 120 at the margins, a sufficient degree of elasticity is generated that allows bending in the direction of arrow 116.

The electrically conductive lead 106 is formed within a metallization layer as a straight line separated by gaps 128 from a ground plane layer 122. An electrically insulating protective layer is deposited to cover the electrically conductive layer. In order to lower the rigidity of the webs 120, the ground plane layer 122 is structured that it leaves open the webs 120.

In addition to the LEDs 102, the lighting module 100 further comprises capacitors 124 which are also formed as SMD components. The LEDs 102 advantageously are formed as a standard SMD LED package with four terminals (three anode terminals A and one cathode terminal C, the C terminal being marked by a beveled edge) as this is known in the art.

Fig. 2 shows an example not covered by the claims of the lighting module 100.

According to this example, a connector 126 for connecting the lighting module 100 to an external electronic component is provided on the flat flexible carrier.

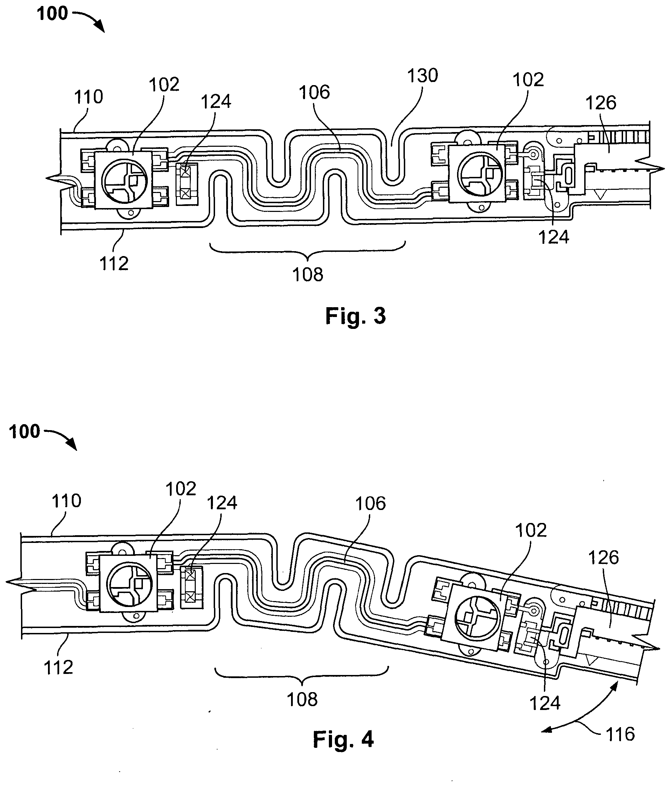

By cutting away the webs 120 a further advantageous structure of the lighting module 100 is created. This modification is shown in Figures 3 and 4. According to an example not covered by the claims, instead of the openings 114 that are surrounded by the flexible substrate 104 on a closed circumference, slits 130 (also called incisions) are provided which are open at the margins 110, 112. Thereby, the flat flexible substrate 104 also has a meander structure that essentially follows the meander structure formed by the electrically conductive lead 106.

As becomes apparent from Fig. 4, this configuration allows the flat flexible carrier (FFC) 132 being bent in the stretchable region 108 as indicated by the arrow 116, thus deforming the flat flexible carrier within the plane defined by the flexible substrate 104. The usual bending in directions which are across to the plane of the flexible substrate 104 is of course also possible, so that the lighting module 100 can be adapted to three-dimensionally complex carrier structures on which it has to be mounted. This is particularly advantageous for applications in a vehicle, such as backlights, brake lights, signaling, interior lighting, or headlights.

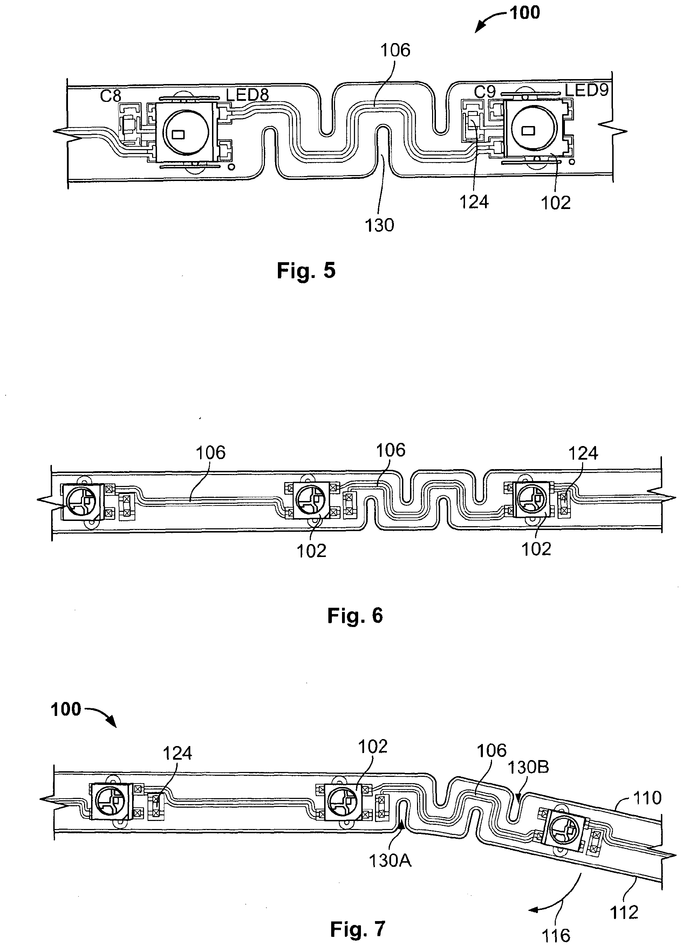

As shown in Figures 5 to 7, the configuration having incisions 130 advantageously is implemented by accordingly structuring the flexible substrate 104. The advantage thereof can be seen in the fact that no separate stamping step has to be performed.

Figures 6 and 7 further illustrate that a bending within the plane defined by the flat flexible substrate 104 only takes place in the stretchable region 108. All remaining parts stay straight. In Fig. 7, the incisions 130A that are located at the margin 112, towards which the right-hand side part of the lighting module 100 is bent, are compressed, while the incisions 130B at the opposing margin 110 are stretched. In other words, by the bending process the first incisions 130A are closed at the margin, while the second incisions 130B are further opened.

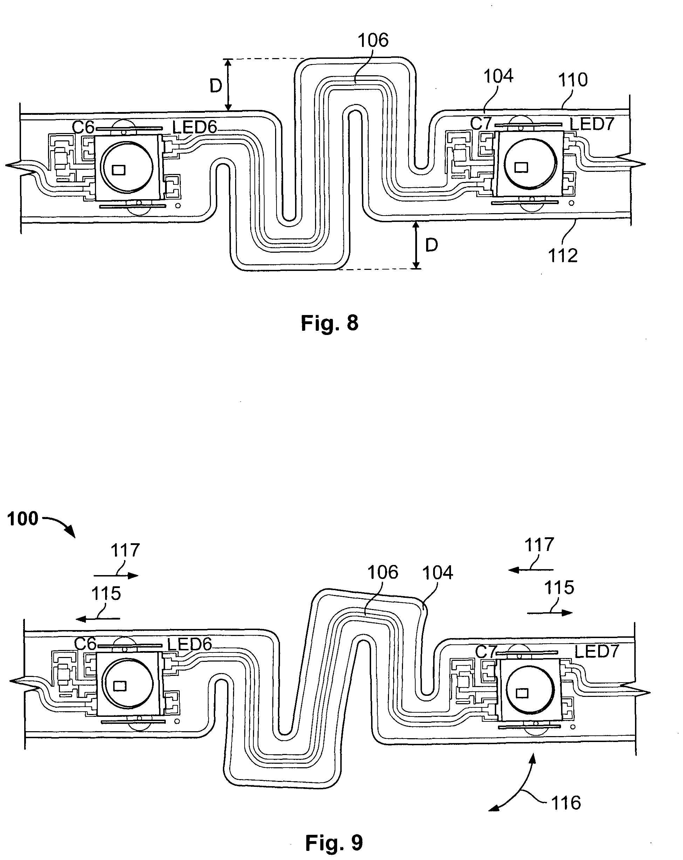

Figures 8 to 10 illustrate an embodiment of the lighting module 100 according to the present invention. According to this embodiment, in the stretchable region 108, the electrically conductive leads 106 and the flat flexible substrate 104 are shaped in a way that two of the meander loops extend further from the longitudinal middle axis 118 than the margins 110, 112, respectively, by a distance D. The distance D may advantageously be around 50% of the breadth of the flexible substrate 104 in the remaining regions of the lighting module 100. However, it is clear for a person skilled in the art that the arrangement does not necessarily have to be symmetric with respect to the longitudinal middle axis 118 and that any suitable values for the distance D may be chosen.

The advantage of this arrangement can be seen in the fact that the lighting module 100 may be expanded along the arrows 115, compressed as indicated by the arrows 117, but also angled as indicated by the arrow 116.

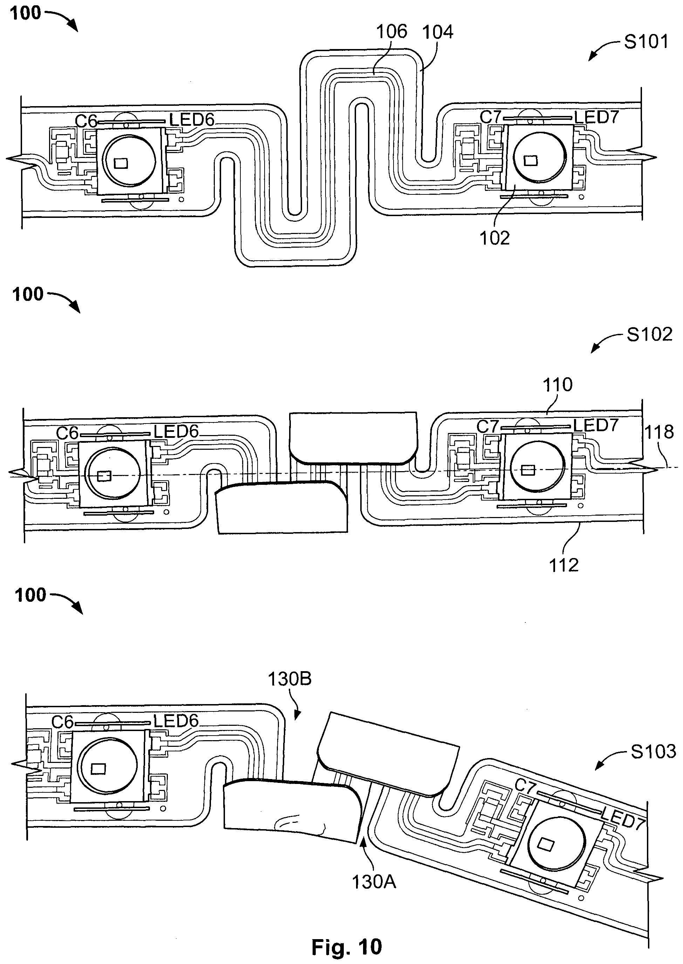

In case the lighting module 100 according to the embodiment shown in Figures 8 and 9 has to be mounted in an area where there is not enough space for the additional distance D, the meander loop areas that are extending over the margins 110, 112 can be folded towards the longitudinal middle axis 118. This process is shown in Fig. 10. In step S 101 the lighting module 100 is provided with the meander structure shown in Fig. 8. Next, the parts of the U-shaped meander loops that are extending further than the margins 110 112, are folded towards the longitudinal middle axis 118 (see step S 102). Finally, if needed, the lighting module 100 may be angled as shown in step S103. Thereby the incisions 130B are expanded, while the incisions 130A are compressed.

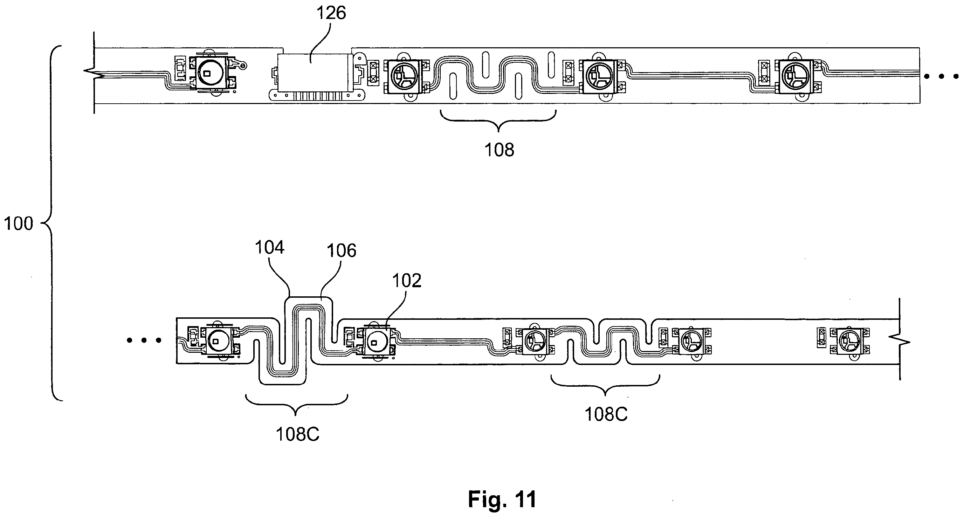

The various examples explained with reference to Figures 1 to 7 may of course also be combined with the embodiment of Fig. 8. Such a configuration is shown schematically in Fig. 11. According to this embodiment, eight LEDs 102 are arranged in a serial configuration. Electrically conductive leads 106 interconnect the LEDs with each other and/or a capacitor 124 and/or a connector 126. Depending on the required degree of angling, three different stretchable regions 108A, 108B, and 108C are provided in accordance with the embodiments explained above.

It is clear for a person skilled in the art, that any other desirable combination of stretchable regions 108 may of course also be implemented.

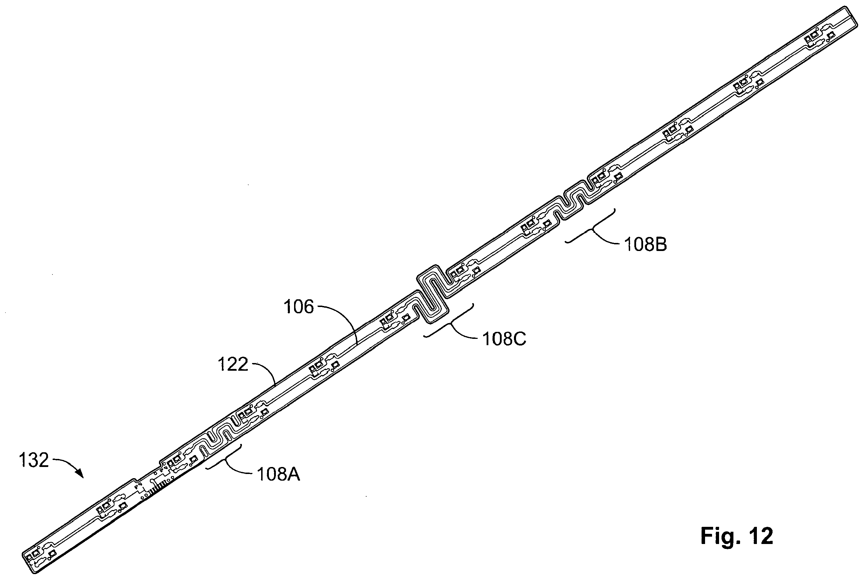

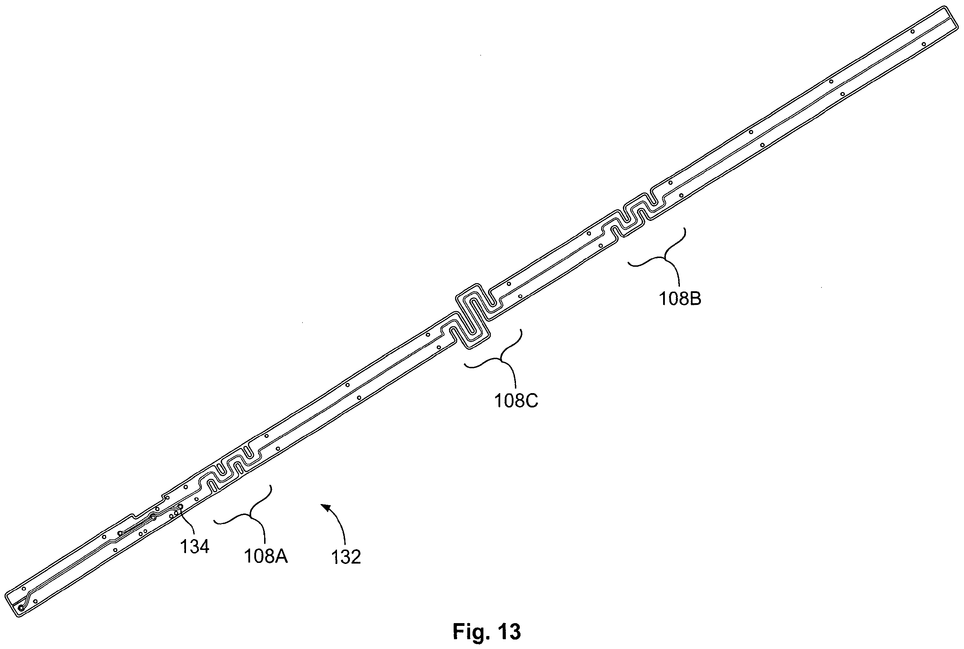

Fig. 12 and 13 illustrate the layout of a flat flexible carrier (FFC) 132 for a lighting module 100 having 12 LEDs and three different stretchable regions 108A, 108B, 100C. In particular, Fig. 12 shows the first surface whereon the electric components and the LEDs are mounted, while Fig. 13 shows the opposing surface of the FFC 132. Vias 134 interconnect metallization layers of the first surface with metallization layers on the second surface.

In summary, the idea according to the present invention makes it possible to stretch and bend a flat flexible circuit board in the plane dimension. This allows more flexibility during installation of the flexible circuit and eliminates tension in the material due to different thermal expansion between the flexible circuit board and a carrier. Thereby the disadvantage of conventional flat straight flexible circuits can be overcome which can only be bent away from the plane surface but have no flexibility in the plane dimension.

The invention proposes implementing meander structures into the flexible circuit design to achieve the required flexibility. The meander structures shown in Fig. 8, as well as combinations of the meander structures shown in Fig. 1 and 3 with that of Fig. 8 are part of this invention which can be used to provide a defined flexibility for different applications. Due to the meander structures in the flexible circuit board, it is possible to mount a flexible circuit board on a flat or curved surface with a certain angle or with a particular flexibility between two or more parts of the flexible circuit board. This allows a flexible circuit board that has been produced in a straight shape to be mounted on a carrier that follows a complex shape which has bends in more than one dimension.

The present invention can advantageously be used for dynamic lighting modules for transportation applications.

### REFERENCE NUMERALS

| **Reference Numeral** | **Description** |
|---|---|
| 100 | Lighting module |
| 102 | Light emitting element; LED |
| 104 | Flat flexible substrate |
| 106 | Electrically conductive lead |
| 108 | Stretchable region |
| 110 | First margin |
| 112 | Second margin |
| 114 | Cut-out |
| 115,116, 117 | Arrows symbolizing deformation |
| 118 | Longitudinal middle axis |
| 120 | Web |
| 122 | Ground plane layer |
| 124 | Capacitor |
| 126 | Electrical connector |
| 128 | Gap |
| 130 | Incision |
| 132 | Flat flexible carrier (FFC) |
| 134 | Via |

## Claims

1. A lighting module comprising:
a flat flexible carrier, the flat flexible carrier comprising at least one electrically insulating flexible substrate (104) with a first surface and a second surface, and at least one planar electrically conductive lead (106) that is arranged on one of the first or second surfaces of said flexible substrate (104); and
at least one light emitting element (102) and at least one electronic component (124), the light emitting element (102) and the electronic component (124, 126) and/or a second light emitting element (102) being electrically connected to each other by means of said at least one electrically conductive lead (106);
wherein, in at least one stretchable region, which is part of the same flat flexible carrier, said conductive lead (106) is patterned to form at least one meander loop, which extends from the longitudinal middle axis (118) further than the first and second margin (110, 112) of the flat flexible carrier outside the stretchable region extending along the longitudinal middle axis, and said substrate (104) has at least one cut-out (114) which forms an incision that is open at the margin (110, 112) of the substrate (104) and that is provided adjacent to the meander loop in a way that the at least one meander loop partly encircles the cut-out (114),
wherein the parts of the loops that extend further than the margins (110, 112) are folded back towards the longitudinal middle axis (118) of the flat flexible substrate (104), so that an essentially straight outline along the first and second margin (110, 112) is formed along the lighting module (100).

2. The lighting module according to claim 1, wherein said at least one electronic component (124, 126) comprises at least one of a capacitor and an electrical connector to be connected to an external electronic component.

3. The lighting module according to one of the preceding claims, wherein the at least one light emitting element (102) comprises a light emitting diode (LED).

4. The lighting module according to one of the preceding claims, wherein the light emitting element (102) and/or the electronic component (124, 126) comprise a surface mount device (SMD).

5. The lighting module according to one of the preceding claims, wherein the at least one electrically conductive (106) lead is covered at least partly by an electrically insulating protective layer (122).

6. The lighting module according to one of the preceding claims, wherein said at least one electrically conductive lead (106) comprises a strip line separated from a grounding plane layer by gaps running in parallel to the strip line.

7. The lighting module according to one of the preceding claims, wherein the electrically insulating flexible substrate is fabricated from polyimide, acrylate, or flexible ceramic, and/or wherein the at least one electrically conductive lead is fabricated from a metal or metal alloy or from a polymer filled with conductive particles.

8. The lighting module according to one of the preceding claims, further comprising embedded rigid areas for assembling said light emitting element and/or the electronic component.

9. The lighting module according to one of the preceding claims, wherein the at least one stretchable region separates regions where at least one light emitting element and/or electronic component are assembled.

10. Method of fabricating a lighting module, the method comprising the steps of:
fabricating a flat flexible carrier, the carrier comprising at least one electrically insulating flexible substrate (104) with a first surface and a second surface, and at least one planar electrically conductive lead (106) that is arranged on one of the first or second surfaces of said flexible substrate; and
assembling at least one light emitting element (102) and at least one electronic component (124), the light emitting element and the electronic component and/or a second light emitting element being electrically connected to each other by means of said at least one electrically conductive lead; wherein, in at least one stretchable region, which is part of the same flat flexible carrier, said conductive lead is patterned to form at least one meander loop, and said substrate has at least one cut-out (114) which forms an incision that is open at the margin of the substrate and that is provided adjacent to the meander loop in a way that the at least one meander loop partly encircles the cut-out,
wherein the flat flexible carrier outside the stretchable region has a first and second margin extending along the longitudinal middle axis, and wherein, in the stretchable region, the electrically conductive lead forms at least one meander loop that extends from the longitudinal middle axis further than the first and second margin, and wherein the method further comprises the step of folding back towards the centre of the flat flexible carrier the part of the loops that extends further than the margins, so that an essentially straight outline along the first and second margin is formed.

11. Method according to claim 10, wherein the cut-out is formed by stamping the flat flexible carrier.

## Patentansprüche

1. Beleuchtungsmodul, das umfasst:
einen flachen flexiblen Träger, wobei der flache flexible Träger wenigstens ein elektrisch isolierendes flexibles Substrat (104) mit einer ersten Fläche und einer zweiten Fläche sowie wenigstens eine planare elektrisch leitende Leitung (106) umfasst, die an der ersten oder der zweiten Fläche des flexiblen Substrats (104) angeordnet ist; und
wenigstens ein lichtemittierendes Element (102) sowie wenigstens ein elektronisches Bauteil (124), wobei das lichtemittierende Element (102) und das elektronische Bauteil (124, 126) und/oder ein zweites lichtemittierendes Element (102) mittels der wenigstens einen elektrisch leitenden Leitung (106) elektrisch miteinander verbunden sind;
wobei in wenigstens einem dehnbaren Bereich, der Teil desselben flachen flexiblen Trägers ist, die leitende Leitung (106) so strukturiert ist, dass sie wenigstens eine mäanderförmige Schleife bildet, die sich von der Längs-Mittelachse (118) weiter als der erste und der zweite Rand (110, 112) des flachen flexiblen Trägers außerhalb des dehnbaren Bereiches erstreckt, der sich entlang der Längs-Mittelachse erstreckt, und das Substrat (104) wenigstens einen Ausschnitt (114) aufweist, der einen Einschnitt bildet, der an dem Rand (110, 112) des Substrats (104) offen ist und der an die mäanderförmige Schleife so angrenzt, dass die wenigstens eine mäanderförmige Schleife den Ausschnitt (114) teilweise umschließt,
wobei die Teile der Schleifen, die sich weiter erstrecken als die Ränder (110, 112), in Richtung der Längs-Mittelachse (118) des flachen flexiblen Substrats (104) so umgeschlagen sind, dass ein im Wesentlichen gerader Umriss entlang des ersten und des zweiten Randes (110, 112) entlang des Beleuchtungsmoduls (100) gebildet wird.

2. Beleuchtungsmodul nach Anspruch 1, wobei das wenigstens eine elektronische Bauteil (124, 126) wenigstens einen Kondensator sowie einen elektrischen Verbinder umfasst, der mit einem externen elektronischen Bauteil verbunden wird.

3. Beleuchtungsmodul nach einem der vorangehenden Ansprüche, wobei das wenigstens eine lichtemittierende Element (102) eine Leuchtdiode (LED) umfasst.

4. Beleuchtungsmodul nach einem der vorangehenden Ansprüche, wobei das lichtemittierende Element (102) und/oder das elektronische Bauteil (124, 126) ein oberflächenmontiertes Bauteil (SMD) umfassen/umfasst.

5. Beleuchtungsmodul nach einem der vorangehenden Ansprüche, wobei die wenigstens eine elektrisch leitende Leitung (106) wenigstens teilweise mit einer elektrisch isolierenden Schutzschicht (122) abgedeckt ist.

6. Beleuchtungsmodul nach einem der vorangehenden Ansprüche, wobei die wenigstens eine elektrisch leitende Leitung (106) eine Streifenleitung umfasst, die durch parallel zu der Streifenleitung verlaufende Spalte von einer Masseflächen-Schicht getrennt ist.

7. Beleuchtungsmodul nach einem der vorangehenden Ansprüche, wobei das elektrisch isolierende flexible Substrat aus Polyimid, Acrylat oder flexibler Keramik hergestellt ist und/oder wobei die wenigstens eine elektrisch leitende Leitung aus einem Metall oder einer Metalllegierung oder aus einem mit leitenden Teilchen gefüllten Polymer hergestellt ist.

8. Beleuchtungsmodul nach einem der vorangehenden Ansprüche, das des Weiteren eingebettete starre Bereiche zum Montieren des lichtemittierenden Elementes und/oder des elektronischen Bauteils umfasst.

9. Beleuchtungsmodul nach einem der vorangehenden Ansprüche, wobei der wenigstens eine dehnbare Bereich Bereiche Trend, in denen wenigstens ein lichtemittierendes Element und/oder ein elektronisches Bauteil montiert sind/ist.

10. Verfahren zum Herstellen eines Beleuchtungsmoduls, wobei das Verfahren die folgenden Schritte umfasst:
Herstellen eines flachen flexiblen Trägers, wobei der Träger wenigstens ein elektrisch isolierendes flexibles Substrat (104) mit einer ersten Fläche und einer zweiten Fläche sowie wenigstens eine planare elektrisch leitende Leitung (106) umfasst, die an der ersten oder der zweiten Fläche des flexiblen Substrats (104) angeordnet ist; und
Montieren wenigstens eines lichtemittierenden Elementes (102) und wenigstens eines elektronischen Bauteils (124), wobei das lichtemittierende Element und das elektronische Bauteil und/oder ein zweites lichtemittierendes Element mittels der wenigstens einen elektrisch leitenden Leitung elektrisch miteinander verbunden sind;
wobei in wenigstens einem dehnbaren Bereich, der Teil desselben flachen flexiblen Trägers ist, die leitende Leitung so strukturiert ist, dass sie wenigstens eine mäanderförmige Schleife bildet, und das Substrat wenigstens einen Ausschnitt (114) aufweist, der einen Einschnitt bildet, der an dem Rand des Substrats offen ist und der an die mäanderförmige Schleife so angrenzt, dass die wenigstens eine mäanderförmige Schleife den Ausschnitt teilweise umschließt,
wobei der flache flexible Träger außerhalb des dehnbaren Bereiches einen ersten und einen zweiten Rand aufweist, die sich entlang der Längs-Mittelachse erstrecken, und in dem dehnbaren Bereich die elektrisch leitende Leitung wenigstens eine mäanderförmige Schleife bildet, die sich von der Längs-Mittelachse weiter als der erste und der zweite Rand des flachen flexiblen Trägers erstreckt, und das Verfahren des Weiteren den Schritt umfasst, in dem der Teil der Schleifen, der sich weiter erstreckt als die Ränder, in Richtung der Mitte des flachen flexiblen Trägers so umgeschlagen wird, dass ein im Wesentlichen gerader Umriss entlang des ersten und des zweiten Randes gebildet wird.

11. Verfahren nach Anspruch 10, wobei der Ausschnitt durch Stanzen des flachen flexiblen Trägers ausgebildet wird.

## Revendications

1. Module d'éclairage comprenant :
un support souple plat, le support souple plat comprenant au moins un substrat souple (104) électriquement isolant, comportant une première surface et une seconde surface, et au moins un conducteur électrique plan (106) qui est disposé sur l'une de la première et de la seconde surface dudit substrat souple (104), et
au moins un élément électroluminescent (102) et au moins un composant électronique (124), l'élément électroluminescent (102) et le composant électronique (124, 126) et/ou un second élément électroluminescent (102) étant électriquement reliés l'un à l'autre au moyen dudit conducteur électrique (106),
dans lequel, dans au moins une zone étirable, qui fait partie du même support souple plat, ledit conducteur (106) est façonné de sorte à former au moins une boucle de méandre qui s'étend depuis l'axe médian longitudinal (118) au-delà de la première et de la seconde marge (110, 112) du support souple plat à l'extérieur de la zone étirable se déployant le long de l'axe médian longitudinal, et ledit substrat (104) comporte au moins une découpe (114) qui forme une incision qui est ouverte au niveau de la marge (110, 112) du substrat (104) et qui est disposée pour être adjacente à la boucle de méandre de telle sorte que la ou les boucles de méandre encerclent partiellement la découpe (114),
dans lequel les parties des boucles qui s'étendent au-delà des marges (110, 112) sont repliées en direction de l'axe médian longitudinal (118) du substrat souple plat (104) de telle sorte qu'il est formé un contour pratiquement droit le long du module d'éclairage (100) le long de la première et de la seconde marge (72, 112).

2. Module d'éclairage selon la revendication 1, dans lequel ledit ou lesdits composants électroniques (124, 126) comprennent au moins l'un parmi un condensateur et un connecteur électrique à connecter à un composant électronique externe.

3. Module d'éclairage selon l'une des revendications précédentes, dans lequel le ou les éléments électroluminescents (102) comprennent une diode électroluminescente (LED).

4. Module d'éclairage selon l'une des revendications précédentes, dans lequel l'élément électroluminescent (102) et/ou le composant électronique (124, 126) comprennent un composant à montage en surface (SMD ou CMS).

5. Module d'éclairage selon l'une des revendications précédentes, dans lequel le ou les conducteurs électriques (106) sont couverts au moins partiellement par une couche protectrice (122) électriquement isolante.

6. Module d'éclairage selon l'une des revendications précédentes, dans lequel ledit ou lesdits conducteurs électriques (106) comprennent une ligne à ruban séparée d'une couche formant plan de masse par des intervalles s'étirant en parallèle de la ligne à ruban.

7. Module d'éclairage selon l'une des revendications précédentes, dans lequel le substrat souple électriquement isolant est fabriqué à partir de polyimide, acrylate ou céramique souple, et/ou dans lequel au moins un conducteur électrique est fabriqué à partir d'un métal ou d'un alliage métallique ou bien à partir d'un polymère comprenant des particules conductrices.

8. Module d'éclairage selon l'une des revendications précédentes, comprenant en outre des zones rigides intégrées permettant d'assembler ledit élément électroluminescent et/ou le composant électronique.

9. Module d'éclairage selon l'une des revendications précédentes, dans lequel la ou les zones étirables séparent des zones où sont assemblés au moins un élément électroluminescent et/ou un composant électronique.

10. Procédé de fabrication d'un module d'éclairage, le procédé comprenant les étapes suivantes :
la fabrication d'un support souple plat, le support comprenant au moins un substrat souple (104) électriquement isolant comportant une première surface et une seconde surface et au moins un conducteur électrique plan (106) qui est disposé sur l'une de la première ou de la seconde surface dudit substrat souple, et
l'assemblage d'au moins un élément électroluminescent (102) et d'au moins un composant électronique (124), l'élément électroluminescent et le composant électronique/un second élément électroluminescent étant reliés électriquement l'un à l'autre au moyen dudit ou desdits conducteurs électriques,
dans lequel, dans au moins une zone étirable, qui fait partie du même support souple plat, ledit conducteur est façonné pour former au moins une boucle de méandre et ledit substrat comporte au moins une découpe (114) qui forme une incision qui est ouverte au niveau de la marge du substrat, et qui est disposée pour être adjacente à la boucle de méandre de telle sorte que la ou les boucles de méandre encerclent partiellement la découpe,
dans lequel le support souple plat à l'extérieur de la zone étirable comporte une première et une seconde marge s'étendant le long de l'axe médian longitudinal, et dans lequel, dans la zone étirable, le conducteur électrique forme au moins une boucle de méandre qui se déploie depuis l'axe médian longitudinal au-delà de la première et de la seconde marge, et où le procédé comprend en outre l'étape consistant à replier vers le centre du support souple plat la partie de la boucle qui s'étend au-delà des marges de telle sorte que soit formé un contour pratiquement droit le long de la première et de la seconde marge.

11. Procédé selon la revendication 10, dans lequel la découpe est formée par le matriçage du support souple plat.
